# EUROPEAN PATENT SPECIFICATION

(11) **EP 2 710 793 B1**
(45) Date of publication and mention of the grant of the patent: **31.08.2016**
(21) Application number: 12785309.1
(22) Date of filing: 17.05.2012
(51) Int. Cl.: H04N 5/225, G03B 17/02

(54) **CAMERA MODULE**
KAMERAMODUL
MODULE DE CAMÉRA

(30) Priority: 18.05.2011 KR 20110046966; 13.07.2011 KR 20110069335; 16.05.2012 KR 20120051778
(43) Date of publication of application: 26.03.2014
(60) Divisional application: 16178719.7
(73) Proprietor: LG Innotek Co., Ltd., Seoul 100-714 (KR)
(72) Inventor: HAN, Kwangjoon, Seoul 100-714 (KR)
(74) Representative: DREISS Patentanwälte PartG mbB
(86) International application number: PCT/KR2012/003914
(87) International publication number: WO 2012/157985

(56) References cited:
- EP-A1- 1 890 180
- WO-A1-2010/129454
- WO-A2-2011/008443
- JP-A- H0 360 186
- KR-A- 20040 077 057
- US-A1- 2004 132 491
- US-A1- 2006 280 493
- US-A1- 2009 213 232
- US-A1- 2010 158 508
- US-A1- 2011 085 072

## Description

### Technical Field

The present invention relates to a camera module.

### Background Art

A PCB (Printed Circuit Board) is a component connecting an electric circuit between electronic components to supply a power and a control signal. Recently, a camera module performing an auto focusing operation using an actuator has been developed, where two electrodes of an AF (Auto Focus) terminal and a PCB AF pad are conductively connected to controllably drive the actuator.

The actuator needs to receive a control signal and a power by connecting the PCB mounted with an image sensor, and to this end, a separate connection substrate functioning as a wiring is generally provided between the actuator and the PCB. However, in a case the connection substrate is separately provide as mentioned above, there is a problem in manufacturing the connection substrate and managing stock control. Another problem is that size of the camera module increases as much as volume of the connection substrate.
EP 1 890 180 A1 discloses a lens unit comprising an lens having a focal length variable in response to an applied electric field and an electrical connector.
WO 2010/129454 A1 discloses an electrically controllable optical lens apparatus having an active optical element.
WO 2011/008443 A2 discloses a wafer level camera module connectable to a host device via mounting surface contacts.
US 2009/0213232 A1 discloses an image pickup device in which a wiring and relay terminals for electrically connecting a shutter driving section with a shutter driver are integrally formed with a solid wiring board and a lens tube respectively.
US 2010/0158508 A1 discloses a camera module with a lens part including a lens and a lens barrel, a holder coupled with the lens part and formed with a first conductive layer, and a printed circuit board electrically connected to the first conductive layer while supporting the holder.
JP H03 60186 A discloses a conductive copper layer formed on a ceramic substrate.

### Disclosure of Invention

### Technical Problem

The present invention is disclosed to provide a camera module improved in structure by forming an electronic circuit on a surface of an electronic component when the electronic component is injection-molded and dispensing with a separate PCB.

### Solution to Problem

An object of the invention is to solve at least one or more of the above problems and/or disadvantages in whole or in part and to provide at least the advantages described hereinafter. In order to achieve at least the above objects, in whole or in part, and in accordance with the purpose of the invention, as embodied and broadly described, and in one general aspect of the present invention, there is provided a camera module according to claim 1.

Preferably, but not necessarily, the electronic circuit pattern layer is formed only on one side of the holder.

Preferably, but not necessarily, the electronic circuit pattern layer is formed on an outside and an inside of the holder.

Preferably, but not necessarily, the electronic circuit pattern layer is further formed at an upper side thereof with a conductive layer stacked with conductive materials.

Preferably, but not necessarily, the conductive layer is formed at the upper side of the electronic circuit pattern layer using any one technical engineering of coating and plating.

Preferably, but not necessarily, the electronic circuit pattern layer is directly mounted with electronic components.

Preferably, but not necessarily, the actuator is formed with at least two or more connection terminals.

Preferably, but not necessarily, one of the connection terminals is connected to a positive terminal and the other of the connection terminals is connected to a ground terminal.

Preferably, but not necessarily, the connection terminals are conductively connected to the electronic circuit pattern layer by way of any one method of soldering, wire bonding and AG epoxy bonding.

Preferably, but not necessarily, the connection terminals are conductively and directly connected to the electronic circuit pattern layer.

Preferably, but not necessarily, the terminal of the PCB is conductively connected to the electronic circuit pattern layer by way of any one method of soldering, wire bonding and AG epoxy bonding.

Preferably, but not necessarily, the terminal of the PCB is conductively and directly connected to the electronic circuit pattern layer.

Preferably, but not necessarily, the actuator performs any one of auto focusing function, hand-shake prevention function, shutter function and zooming function.

Preferably, but not necessarily, the actuator is formed with one of an optical diaphragm on an optical path of the lenses and a liquid crystal micro lens, wherein either the optical diaphragm on an optical path of the lenses or the liquid crystal micro lens adjusts refraction of light passing the lenses to focus an image captured by the image sensor.

Preferably, but not necessarily, the actuator is formed with any one of a non-MEMS actuator including a MEMS actuator, a liquid crystal lens and a piezo polymer lens, a silicon type actuator and a liquid lens.

Preferably, but not necessarily, the holder is integrally formed with a base arranged at the upper surface of the PCB.

Preferably, but not necessarily, the holder is a cylindrical camera unit formed at an upper surface of the base, where a diameter of the holder at a portion arranged with a lens with a larger diameter and a diameter of the holder at a portion arranged with a relatively smaller diameter are differently formed.

Preferably, but not necessarily, the holder is formed with a constant diameter toward the upper surface of the base.

In another aspect of the present invention, there is provided a camera module, comprising: a PCB (Printed Circuit Board) formed with an image sensor; a holder formed at an upper surface of the PCB and mounted therein with at least one or more lenses; and an actuator positioned at the holder to focus an image captured by the image sensor using the at least one lens, wherein the actuator and the PCB are connected through an electronic circuit pattern layer formed at the holder.

### Advantageous Effects of Invention

The camera module according to the present invention has an advantageous effect in that an electronic circuit can be formed on a surface of an injection-molded electronic component in the same method as that of formation of an electronic circuit pattern layer on the surface of the electronic component to form a circuit on a PCB, whereby the electronic components can be manufactured at a more reasonable price.

Another advantage is that a reduced difficulty in manufacturing process enables manufacturing of a product with a constant level of reliability regardless of skill of an operator, whereby a processing cost can be reduced.

### Brief Description of Drawings

The teachings of the present invention can be readily understood by considering the following detailed description in conjunction with the accompanying drawings, in which:
FIG. 1 is a schematic view illustrating an electronic circuit formed on a surface of a camera module according to an exemplary embodiment of the present invention; and
FIGS. 2, 3 and 4 are schematic views illustrating a process of forming an electronic circuit on a surface of a holder according to an exemplary embodiment of the present invention.

### Best Mode for Carrying out the Invention

The following description is not intended to limit the invention to the form disclosed herein. Consequently, variations and modifications commensurate with the following teachings, and skill and knowledge of the relevant art are within the scope of the present invention. The embodiments described herein are further intended to explain modes known of practicing the invention and to enable others skilled in the art to utilize the invention in such, or other embodiments and with various modifications required by the particular application(s) or use(s) of the present invention.

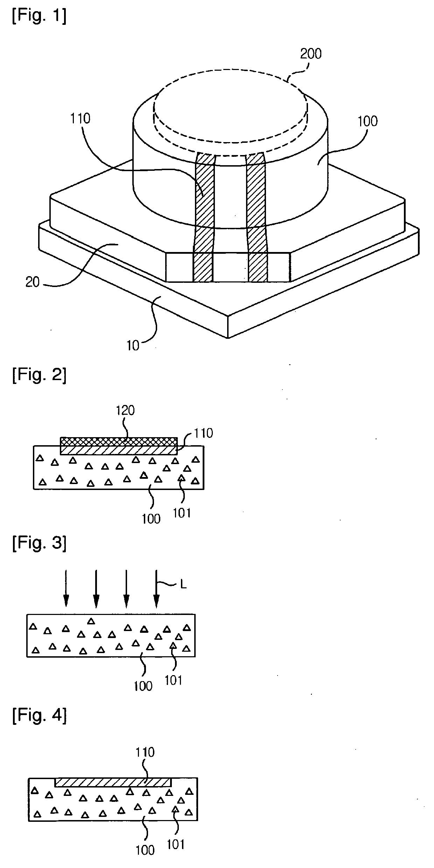

The disclosed embodiments and advantages thereof are best understood by referring to FIGS. 1-4 of the drawings, like numerals being used for like and corresponding parts of the various drawings. Other features and advantages of the disclosed embodiments will be or will become apparent to one of ordinary skill in the art upon examination of the following figures and detailed description. It is intended that all such additional features and advantages be included within the scope of the disclosed embodiments, and protected by the accompanying drawings. Further, the illustrated figures are only exemplary and not intended to assert or imply any limitation with regard to the environment, architecture, or process in which different embodiments may be implemented. Accordingly, the described aspect is intended to embrace all such alterations, modifications, and variations that fall within the scope and novel idea of the present invention.

Meanwhile, the terminology used herein is for the purpose of describing particular implementations only and is not intended to be limiting of the invention. That is, as used herein, the singular forms "a", "an" and "the" are intended to include the plural forms as well, unless the context clearly indicates otherwise.

It will be further understood that the terms "including", "includes", "having", "has", "with", or variants thereof are used in the detailed description and/or the claims to denote non-exhaustive inclusion in a manner similar to the term "comprising".

Also, "exemplary" is merely meant to mean an example, rather than the best. If is also to be appreciated that features, layers and/or elements depicted herein are illustrated with particular dimensions and/or orientations relative to one another for purposes of simplicity and ease of understanding, and that the actual dimensions and/or orientations may differ substantially from that illustrated.

As may be used herein, the terms "substantially" and "approximately" provide an industry-accepted tolerance for its corresponding term and/or relativity between items. Such an industry-accepted tolerance ranges from less than one percent to ten percent and corresponds to, but is not limited to, component values, angles, et cetera.

That is, in the drawings, the size and relative sizes of layers, regions and/or other elements may be exaggerated or reduced for clarity. Like numbers refer to like elements throughout and explanations that duplicate one another will be omitted.

Now, a camera module according to the present invention will be described in detail with reference to the accompanying drawings.

FIG. 1 is a schematic view illustrating an electronic circuit formed on a surface of a camera module according to an exemplary embodiment of the present invention, where a holder useable as a barrel or a camera housing forming a camera module is injection-molded and an electronic circuit is formed on a surface of the holder.

Referring to FIG.1, the camera module according to the present invention includes a PCB (10, Printed Circuit Board), a base (20), a holder (100), an electronic circuit pattern layer (110) and an actuator (200).

The PCB (10) may be provided with a plurality of terminals and mounted at an approximate center of the PCB (10) with an image sensor. The PCB (10) is connected to the actuator (200) via the electronic circuit pattern layer (110) formed on a surface of holder (100). Although not illustrated, an image sensor and various electronic components are formed on the surface of the PCB (10). The PCB (10) may be formed by using FR-4 (woven glass and epoxy), FR-5 (woven glass and epoxy) and ceramic materials. The PCB (10) may be provided with a terminal for connecting to the actuator (200). The terminal is preferably connected to the electronic circuit pattern layer (110) using soldering, but the connection method is not limited thereto and may be connected by wire bonding, AG epoxy bonding or direct connection.

The base (20) may be injection-molded with resin material such as plastic, and formed with an infrared cut-off filter on a surface opposite to the image sensor. The holder (100) is arranged at an upper surface of the base (20) and may be installed therein with at least one sheet of lens. The holder (20), as illustrated in FIGS. 2, 3 and 4, includes at least one impurity (101), and may be injection-molded with a material changeable in physical property if applied with any one of heat and light, and integrally formed with the base (20), if necessary.

The holder (100) is formed with at least two cylinders each having a different diameter, the configuration of which is made in consideration of sizes of diameters based on difference of magnification of lens mounted inside the holder (100).

As noted above, if the holder (100) is configured to have different diameters in consideration of diameters of lenses mounted thereinside, thickness of the holder (100) can be equally controlled when the holder (100) is injection molded. If thickness of a part is not equally configured, resin may not be introduced into a mold when the thickness is suddenly thinned, and when thickness of a part is suddenly thickened, resin is not fully supplied to the mold at a thickened portion to result in failure of normal injection of the thickened portion, such that it is preferable that the thickness of each part be equally formed if possible. It is also preferable that the holder (100) be provided with a plurality of cylinders each having a different diameter in consideration of each diameter of embedded plurality of lenses.

However, it should be noted that the shape of holder (100) is not limited to being formed with the multi-staged cylinders. Where necessary, the holder (100) may alternatively or selectively take the shape of a multi-staged rectangular shape or a multi-staged polygonal shape. In addition, the holder (100) may take the shape of a round pillar or a square pillar each having a predetermined diameter or a predetermined width.

According to an exemplary embodiment of the present invention, as illustrated in FIG.1, the holder (100) useable as a barrel or a camera housing of a camera module may be integrally provided with the base (20) interposed between the PCB (10) and the holder (100). According to the configuration thus mentioned, the electronic circuit pattern layer (110) and/or a conductive layer (120) may be formed on a surface of the holder (100) including the base (20).

The actuator (200) may be positioned at the holder (100) to add a focus adjusting function of the camera module, and arranged at an upper surface of the holder (100) as shown in FIG.1, where a mounted position of the actuator (200) may be changed within a design-allowable range. The terminal of the actuator (200) is conductively connected to the electronic circuit pattern layer (110) formed at the holder (100), where the electronic circuit pattern layer (110) is conductively connected to the terminal of the PCB (10). Furthermore, in a case a conductive layer (120) of metal material is provided at the upper surface of the electronic circuit pattern layer (110), the power and control signal may be received through the conductive layer (120).

The actuator (200) may take various shapes depending on necessity thereof. For example, the actuator (200) may be formed in any one type of piezo/polymer lenses, optical diaphragms, liquid crystal micro lenses, MEMS actuator, MEMS piezo actuator, MEMS bimorphactuator, MEMS thermal actuator, MEMS magnetic actuator, MEMS liquid actuator, non-MEMS type actuator, silicone type actuator and liquid lenses. Furthermore, combination of these types may also alternatively replace the actuator (200). The actuator (200) may use at least one lens to perform auto focusing function, hand shake prevention function, shutter function and zooming function of an image captured by the image sensor.

Meanwhile, the actuator (200) is provided with at least two connection terminals that can be connected to a plus terminal and a ground terminal, where the connection terminals (121) are preferably connected to an electronic circuit pattern layer (100) via soldering, wire bonding or Ag epoxy method.

With reference to FIG.1 again, the plurality of connection terminals, preferably at least two or more connection terminals, is so configured that one connection terminal is preferably connected to a plus terminal and the other connection terminal is connected to a ground terminal.

The actuator (200) is susceptible to influences by an axial alignment and trembling of the lens, such that the actuator (200) needs to be firmly fixed to the holder (100), and the connection terminals are preferably connected by way of soldering or wire bonding.

Signal exchange with the actuator (200) is performed through the electronic circuit pattern layer (110) or the conductive layer (120), such that the cumbersomeness of using a complicated wiring, manufacturing of a separate PCB or FPCB for signal exchange and mounting same to the holder (100) can be eliminated to enable a reasonable cost of manufacturing of product.

### Mode for the Invention

Meanwhile, the technique of forming the electronic circuit pattern layer (100) is generally called an MID (Molded Interconnect Device) technology, where the MID technology is largely divided into three types.

First, a 2S method is provided such that a portion forming the holder (100) and a portion forming the electronic circuit pattern layer (110) are respectively injection molded with a different synthetic resin material, where the holder (100) is injection molded with an insulation material, while the portion forming the electronic circuit pattern layer (110) is formed with conductive synthetic resin, or formed with synthetic resin that can be easily gold-plated, and injection molded. After the holder (100) is injection molded, the electronic circuit pattern layer (110) is completed using a subsequent process such as a plating process.

Second, an LDS (Laser Direct Structuring) method is provided such that the holder (100) included with impurities reacting to light and heat is injection molded, the injection molded holder (100) is formed with a wiring pattern where the electronic circuit pattern layer (110) is to be formed through a surface patterning process such as a laser exposing method.

That is, FIG.3 schematically illustrates configuration of the holder (100) that is injection molded with a material whose physical properties change if at least one of heat and light is applied including at least one or more impurities (101).

With continuing reference to FIG.3, the holder (100) injection molded with impurities (101) is changed in physical properties at a portion where light is incident, if exposed to light through a means capable of transmitting light such as laser beam (L) and/or heat. That is, in a case laser beam (L) is incident, and a surface of the body is heated and/or exposed to the light, the physical properties of the surface of the holder (100) exposed to the laser beam change due to the influence of impurities (101). This is because the impurities (101) contained in the holder (100) are evaporated or sublimed by light such as laser beam (L) and heat to change surrounding materials.

The impurities (101) may be changed to a state capable of electrically conducting the physical properties of the exposed portion of the holder (100), or to a state of physical properties easy to be plated or coated, if not electrically conducted. The composition or exposing process of the impurities (101) is a known art, such that no further details will be omitted herefrom as less related to the subject matter of the present invention.

Referring to FIG.3 again, the electronic circuit pattern layer (200) may be formed on the portion exposed by the laser beam (L) by way of using the changes in physical properties in the surface of the holder (100) in response to exposure to laser beam (L). That is, in a case the laser beam (L) is irradiated on the surface of the holder (100) in the form of the electronic circuit pattern, the surface of the holder (100) exposed to the laser beam (L) may be formed with an electronic circuit pattern layer (110) having a pattern of an electronic circuit, although not visible to the naked eye.

In a case the electronic circuit pattern layer (110) is formed, the layer (110) can be forthrightly mounted with an SMD (Surface Mounted Part) or an accessorial electronic part, because the electronic circuit pattern layer (110) itself has a conductible physical property. Preferably, a conductible metal layer (220) is further stacked on the surface of the electronic circuit pattern layer (110) using a metal material. That is, the electronic circuit pattern layer (110) may be formed by being plated with a metal material, or by being coated with a conductible material.

Meanwhile, MIPTEC (Microscopic Integrated Processing Technology) method may be provided as another MID technology. The MIPTEC is a method in which patterning is effected by etching a non-circuit portion after front metallizing. That is, an entire surface of the holder (100) is metallized, portions except for a portion to be formed with an electronic circuit pattern layer (110) are etched to integrally form the electronic circuit pattern layer (110) with the holder (100).

Meanwhile, the electronic circuit pattern layer (110) provided by the MID technology may be formed on one side of the surface of the holder (100), if necessary, and may be formed on an exposed surface at the outside and a non-exposure surface at the inside. This is to select an alignment of the electronic circuit pattern layer (110) by way of a single surface or both surfaces depending on a degree that needs a wiring for parts mounting.

Therefore, if it is necessary to mount many electronic parts, a front surface of the holder (100) and a rear surface as well are formed with the electronic circuit pattern layer (110) using the MID technology, on which electronic parts can be mounted.

As noted from the foregoing, if the electronic circuit pattern layer (110) is formed on the surface of the holder (100), a mounting space can be advantageously reduced that needs parts mounting when a miniaturized electronic product is manufactured.

Although not illustrated, in addition to the camera module according to the exemplary embodiment of the present invention, an injection molded body of an electronic product using a PCB may be integrally formed with an electronic circuit. In this case, a circuit pattern formed on the injection molded body can be directly aligned and coupled with SMDs or electronic parts. If the electronic parts are configured thus described, separate PCB manufacturing or processing can be dispensed with, such that disadvantages of coupling a PCB to a body of electronic parts and of wiring process can be eliminated to reduce the number of parts and the manufacturing cost.

The previous description of the disclosure is provided to enable any person skilled in the art to make or use the disclosure.

### Industrial Applicability

The camera module according to the present invention has an industrial applicability in that it can be applied to a camera module having various types of focus-adjusting devices, and a conductible circuit pattern can be formed on apart surface to be mounted with many parts, instead of a separate circuit forming member such as a PCB, to enable realization of a reduced number of parts and miniaturization of a product.

## Claims

1. A camera module, the camera module comprising:
a PCB (Printed Circuit Board) (10) formed with an image sensor;
a holder (100) formed at an upper surface of the PCB (10) and mounted therein with at least one lens;
an actuator (200) positioned at the holder (100);
an electronic circuit pattern layer (110) formed on a surface of the holder (100), the electronic circuit pattern layer (110) connected to a terminal of the actuator (200) and a terminal of the PCB (10); and
a conductive layer (120) of metal material provided at a surface of the electronic circuit pattern layer (110), wherein a power and a control signal are received through the conductive layer (120).

2. The camera module according to claim 1, wherein the electronic circuit pattern layer (110) is formed on a surface of the holder (100) by the MID technology.

3. The camera module according to claim 1 or 2, wherein the electronic circuit pattern layer (110) is formed only on one side of the holder (100).

4. The camera module according to any of the preceding claims, wherein the electronic circuit pattern layer (110) is formed on an outside and an inside of the holder (100).

5. The camera module according to any of the preceding claims, wherein the electronic circuit pattern layer is formed at an upper side thereof with a conductive layer stacked with conductive materials, and the conductive layer is formed at the upper side of the electronic circuit pattern layer (110) using any one technical engineering of coating and plating.

6. The camera module according to any of the preceding claims, wherein the electronic circuit pattern layer (110) is directly mounted with electronic components.

7. The camera module according to any of the preceding claims, wherein the actuator (200) is formed with at least two or more connection terminals, and one of the connection terminals is connected to a positive terminal and the other of the connection terminals is connected to a ground terminal.

8. The camera module according to claim 7, wherein the connection terminals are conductively connected to the electronic circuit pattern layer by way of any one method of soldering, wire bonding and AG epoxy bonding, and the connection terminals are conductively and directly connected to the electronic circuit pattern layer (110).

9. The camera module according to any of the preceding claims, wherein the terminal of the PCB (10) is conductively connected to the electronic circuit pattern layer (110) by way of any one method of soldering, wire bonding and AG epoxy bonding.

10. The camera module according to any of the preceding claims, wherein the terminal of the PCB (10) is conductively and directly connected to the electronic circuit pattern layer (110).

11. The camera module according to any of the preceding claims, wherein the actuator (200) performs any one of auto focusing function, hand-shake prevention function, shutter function and zooming function, and
the actuator (200) is formed with one of an optical diaphragm on an optical path of the lenses and a liquid crystal micro lens,
wherein either the optical diaphragm on an optical path of the lenses or the liquid crystal micro lens adjusts refraction of light passing the lenses to focus an image captured by the image sensor.

12. The camera module according to any of the preceding claims, wherein the actuator (200) is formed with any one of a non-MEMS actuator including a MEMS actuator, a liquid crystal lens and a piezo polymer lens, a silicon type actuator and a liquid lens.

13. The camera module according to any of the preceding claims, wherein the holder (100) is integrally formed with a base (20) arranged at the upper surface of the PCB (10).

14. The camera module according to claim 1, wherein the holder (100) is a cylindrical camera unit formed at an upper surface of the base (20), where a diameter of the holder (100) at a portion arranged with a lens with a larger diameter and a diameter of the holder (100) at a portion arranged with a relatively smaller diameter are differently formed.

15. The camera module according to claim 1, wherein the holder (100) is formed with a constant diameter toward the upper surface of the base (20).

## Patentansprüche

1. Kameramodul, welches Kameramodul enthält:
eine Leiterplatte (gedruckte Schaltungsplatine) (10), die mit einem Bildsensor gebildet ist;
einen an einer oberen Oberfläche der Leiterplatte (10) gebildeten Halter (100), in dem mindestens eine Linse angebracht ist;
eine an dem Halter (100) positionierte Betätigungseinrichtung (200);
eine auf einer Oberfläche des Halters (100) gebildete Elektronikschaltungsmusterschicht (110), wobei die Elektronikschaltungsmusterschicht (110) mit einem Anschluss der Betätigungseinrichtung (200) und einem Anschluss der Leiterplatte (10) verbunden ist; und
eine leitende Schicht (120) aus Metallmaterial, die auf einer Oberfläche der Elektronikschaltungsmusterschicht (110) vorgesehen ist, wobei Leistung und ein Steuerungssignal durch die leitfähige Schicht (120) empfangen werden.

2. Kameramodul nach Anspruch 1, wobei die Elektronikschaltungsmusterschicht (110) auf einer Oberfläche des Halters (100) durch die MID-Technik gebildet ist.

3. Kameramodul nach Anspruch 1 oder 2, wobei die Elektronikschaltungsmusterschicht (110) nur auf einer Seite des Halters (100) gebildet ist.

4. Kameramodul nach einem der vorhergehenden Ansprüche, wobei die Elektronikschaltungsmusterschicht (110) an einer Außenseite und einer Innenseite des Halters (100) gebildet ist.

5. Kameramodul nach einem der vorhergehenden Ansprüche, wobei die Elektronikschaltungsmusterschicht auf ihrer Oberseite mit einer leitfähigen Schicht gebildet ist, die mit leitfähigen Materialien geschichtet ist, und die leitfähige Schicht auf der Oberseite der Elektronikschaltungsmusterschicht (110) durch eine beliebige der Bearbeitungstechniken Beschichten und Galvanisieren gebildet ist.

6. Kameramodul nach einem der vorhergehenden Ansprüche, wobei an der Elektronikschaltungsmusterschicht (110) elektronische Bauelemente direkt montiert sind.

7. Kameramodul nach einem der vorhergehenden Ansprüche, wobei die Betätigungseinrichtung (200) mit mindestens zwei oder mehr Anschlussklemmen gebildet ist, wobei eine der Anschlussklemmen mit einem positiven Anschluss verbunden ist und die andere der Anschlussklemmen mit einem Masseanschluss verbunden ist.

8. Kameramodul nach Anspruch 7, wobei die Anschlussklemmen mit der Elektronikschaltungsmusterschicht mittels eines beliebigen Verfahrens wie Löten, Drahtbonden und Silberepoxidbonden leitend verbunden sind und die Verbindungsklemmen mit der Elektronikschaltungsmusterschicht (110) leitend und direkt verbunden sind.

9. Kameramodul nach einem der vorhergehenden Ansprüche, wobei der Anschluss der Leiterplatte (10) mit der Elektronikschaltungsmusterschicht (110) mittels eines beliebigen Verfahrens wie Löten, Drahtbonden und Silberepoxidbonden leitend verbunden ist.

10. Kameramodul nach einem der vorhergehenden Ansprüche, wobei der Anschluss der Leiterplatte (10) leitend und direkt mit der Elektronikschaltungsmusterschicht (110) verbunden ist.

11. Kameramodul nach einem der vorhergehenden Ansprüche, wobei die Betätigungseinrichtung (200) eine beliebige der Autofokusfunktion, Handshake-Verhinderungsfunktion, Verschlussfunktion und Zoomfunktion durchführt und
die Betätigungseinrichtung (200) entweder mit einer optischen Blende in einem Strahlengang der Linsen oder einer Flüssigkristall-Mikrolinse gebildet ist,
wobei entweder die optische Blende in einem Strahlengang der Linsen oder die Flüssigkristall-Mikrolinse die Brechung des durch die Linsen tretenden Lichts einstellt, um ein von dem Bildsensor erfasstes Bild zu fokussieren.

12. Kameramodul nach einem der vorhergehenden Ansprüche, wobei die Betätigungseinrichtung (200) mit einer beliebigen einer Nicht-MEMS-Betätigungseinrichtung einschließlich einer MEMS-Betätigungseinrichtung, einer Flüssigkristalllinse und einer Piezopolymerlinse, einer Betätigungseinrichtung des Silicium-Typs und einer Flüssiglinse gebildet ist.

13. Kameramodul nach einem der vorhergehenden Ansprüche, wobei der Halter (100) mit einer auf der oberen Oberfläche der Leiterplatte (10) angeordneten Basis (20) einstückig gebildet ist.

14. Kameramodul nach Anspruch 1, wobei der Halter (100) eine zylindrische Kameraeinheit ist, die auf einer oberen Oberfläche der Basis (20) gebildet ist, wobei ein Durchmesser des Halters (100) in einem mit einer Linse versehenen Teil mit einem größeren Durchmesser und ein Durchmesser des Halters (100) in einem Teil mit einem relativ kleineren Durchmesser unterschiedlich gebildet werden.

15. Kameramodul nach Anspruch 1, wobei der Halter (100) mit einem konstanten Durchmesser zu der oberen Oberfläche der Basis (20) hin gebildet ist.

## Revendications

1. Module de caméra, ce module de caméra comprenant .
- une carte de circuit imprimé (PCB) (10) comportant un capteur d'image ;
- un support (100) constitué sur une surface supérieure de la PCB (10) et monté dans celle-ci avec au moins une lentille ;
- un actionneur (200) positionné au niveau du support (100) ;
- une couche avec des motifs de circuit électronique (110) formée sur une surface du support (100), la couche avec des motifs de circuit électronique (110) étant connectée à une borne de l'actionneur (200) et une borne de la PCB (10) ; et
- une couche conductrice (120) d'un matériau métallique fourni au niveau d'une surface de la couche avec des motifs de circuit électronique (110), dans laquelle un signal d'alimentation et un signal de commande sont reçus, par l'intermédiaire de la couche conductrice (120).

2. Module de caméra selon la revendication 1, dans lequel la couche avec des motifs de circuit électronique (110) est formée sur une surface du support (100) grâce à la technologie MID.

3. Module de caméra selon la revendication 1 ou 2, dans lequel la couche avec des motifs de circuit électronique (110) est formée sur un seul côté du support (100).

4. Module de caméra selon l'une quelconque des revendications précédentes, dans lequel la couche avec des motifs de circuit électronique (110) est formée sur l'extérieur et sur l'intérieur du support (100).

5. Module de caméra selon l'une quelconque des revendications précédentes, dans lequel la couche avec des motifs de circuit électronique est formée sur le dessus de celui-ci, et une couche conductrice est constituée en une pile de matériaux conducteurs, et la couche conductrice est formée sur le dessus de la couche avec des motifs de circuit électronique (110) à l'aide de l'un quelconque des procédés techniques de revêtement et de placage.

6. Module de caméra selon l'une quelconque des revendications précédentes, dans lequel la couche avec des motifs de circuit électronique (110) est montée directement avec des composants électroniques.

7. Module de caméra selon l'une quelconque des revendications précédentes, dans lequel l'actionneur (200) est constitué d'au moins deux, voire plus, bornes de connexion, et l'une des bornes de connexion est connectée à une borne positive et l'autre des bornes de connexion est connectée à une borne de mise à la terre.

8. Module de caméra selon la revendication 7, dans lequel les bornes de connexion sont connectées par conductivité à la couche avec des motifs de circuit électronique grâce à l'un quelconque des procédés de brasage, micro-câblage et liaison époxydique AG, et les bornes de connexion sont connectées directement par conductivité à la couche avec des motifs de circuit électronique (110).

9. Module de caméra selon l'une quelconque des revendications précédentes, dans lequel la borne de la PCB (10) est connectée par conductivité à la couche avec des motifs de circuit électronique (110) grâce à l'un quelconque des procédés de brasage, micro-câblage et liaison époxydique AG.

10. Module de caméra selon l'une quelconque des revendications précédentes, dans lequel la borne de la PCB (10) est connectée directement par conductivité à la couche avec des motifs de circuit électronique (110).

11. Module de caméra selon l'une quelconque des revendications précédentes, dans lequel l'actionneur (200) effectue l'une quelconque des fonction auto-focus, fonction stabilisation, fonction obturateur et fonction zoom, et
l'actionneur (200) est constitué de l'un parmi un diaphragme optique sur un chemin optique des lentilles et une microlentille à cristaux liquides,
dans lequel le diaphragme optique sur un chemin optique des lentilles ou de la microlentille à cristaux liquides ajuste la réfraction de la lumière qui traverse les lentilles afin de faire la mise au point sur une image capturée par le capteur d'image.

12. Module de caméra selon l'une quelconque des revendications précédentes, dans lequel l'actionneur (200) comporte l'un quelconque d'un actionneur non MEMS comprenant un actionneur MEMS, une lentille à cristaux liquides et une lentille polymère piézo électrique, un actionneur de type silicium et une lentille liquide.

13. Module de caméra selon l'une quelconque des revendications précédentes, dans lequel le support (100) est constitué en une seule pièce avec une base (20) agencée au niveau de la surface supérieure de la PCB (10).

14. Module de caméra selon la revendication 1, dans lequel le support (100) est un élément de caméra cylindrique constitué sur une surface supérieure de la base (20), où un diamètre du support (100) sur une portion agencée avec une lentille de plus grand diamètre et un diamètre du support (100) sur une portion agencée avec un diamètre relativement plus petit sont constitués de manière différente.

15. Module de caméra selon la revendication 1, dans lequel le support (100) est constitué avec un diamètre constant en direction de la surface supérieure de la base (20).
